# EUROPEAN PATENT SPECIFICATION

(11) **EP 1 404 013 B1**
(45) Date of publication and mention of the grant of the patent: **07.01.2009**
(21) Application number: 02256800.0
(22) Date of filing: 30.09.2002
(51) Int. Cl.: H02M 1/12, H02M 7/5387, H03H 1/00

(54) **A drive controller**
Antriebssteuereinrichtung
Dispositif de commande d'entraînement

(43) Date of publication of application: 31.03.2004
(73) Proprietor: SIEMENS AKTIENGESELLSCHAFT, 80333 München (DE)
(72) Inventor: Thompson, Kenneth, Macclesfield, Cheshire SK10 1BE (GB)
(74) Representative: Humphrey-Evans, Edward John

(56) References cited:
- EP-A- 1 220 432
- DE-A- 10 019 696
- US-A- 5 739 732
- PATENT ABSTRACTS OF JAPAN vol. 1995, no. 10, 30 November 1995 (1995-11-30) & JP 07 170752 A (MATSUSHITA SEIKO CO LTD;OTHERS: 01), 4 July 1995 (1995-07-04)
- CHEN S: "Generation and suppression of conducted EMI from inverter-fed motor drives" INDUSTRY APPLICATIONS CONFERENCE, 1999. THIRTY-FOURTH IAS ANNUAL MEETING. CONFERENCE RECORD OF THE 1999 IEEE PHOENIX, AZ, USA 3-7 OCT. 1999, PISCATAWAY, NJ, USA,IEEE, US, 3 October 1999 (1999-10-03), pages 1583-1589, XP010355068 ISBN: 0-7803-5589-X

## Description

### FIELD OF INVENTION

The present invention relates to drive controllers as used in machinery drives, for motor control and the like. In particular the present invention relates to a drive controller inverter.

### BACKGROUND TO THE INVENTION

In industrial plant, to enable machinery to operate, for example, a conveyor belt in a production line, pumps, compressors, ventilation systems, hoisting gear, cranes etc electric motors are employed. Electric motors may drive machinery directly by means of a clutch, by way of a transmission belt, hydraulic path, or some other means. The motor itself may drive a low wattage (less than 100W) application such as a drive for a laboratory centrifuge or a high wattage (greater than 300KW) application such as a steel press. The motors can be DC or AC, single phase or multiple phase.

Electric motors and other electrical devices are typically controlled by inverters which convert input power to control input signals for the motor or other electrical device. Inverters, themselves, are controlled by a control panel, the inverters being typically dimensioned as a rectangular box 10 x 15 x 20 cm but depending on power requirements, may be much smaller or much larger. Conveniently the converters are packaged with other electrical control equipment.

Since the inverter controllers include keyboard controls and LED/LCD displays, it has been found that the controllers represent a significant cost of the inverters. To overcome this or for other reasons such as overall control integration, inverters have been remotely controlled by software using cabling operated on RS232 protocols or similar. However, it has been found in some applications, that cabling is susceptible to interference. An alternative system is to have single removable keypad/display unit controller which can serve a number of drives other types of controller are known.

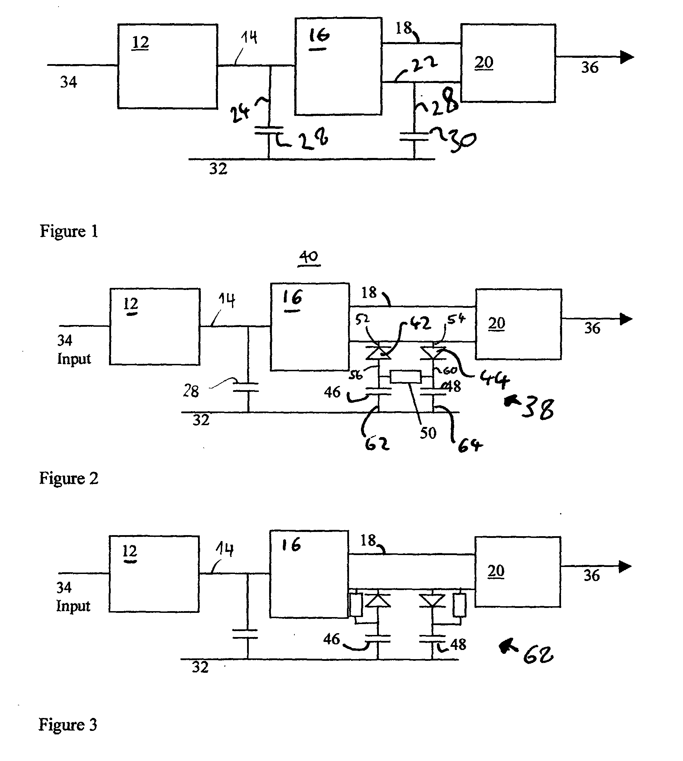

Input power received by inverters is predominantly AC: either single phase or, more typically, three phase. Referring to Figure 1 this AC supply (34) is received by a common mode choke (12). This common mode choke, as is known, operates to suppress electrical noise. This common mode choke is connected to a bridge rectifier (16) by link (14), and by a capacitor (28) to earth potential (32). The bridge rectifier is connected via a first and second DC links (18, 22) to bi-polar transistors in an output stage (20), the second DC link being connected via capacitor (30) to earth. The first and second DC links correspond to the positive and negative or negative and positive leads to the transistor arrangement, depending upon the basic polarity set-up. From the output stage a cable is connected to the motor drive under the control of the inverter. It will be appreciated that this filter circuit will have a resonance characteristic at a particular frequency known as the resonant frequency. For a typical inverter the resonant frequency is 6 kHz which is in the middle of the possible switching frequencies for a typical inverter. The choice of frequency of operation for an inverter is dependent on many conditions. If the inverter runs close to the resonant frequency of the inductor capacitor circuit, and the conductor capacitor circuit resonates, then this will lead to an excessive saturation of the common mode choke. That is to say that the inductance reduces and the filtering action of the choke is dramatically reduced. This can have serious consequences for other control circuits, either directly or indirectly connected to the inverter of interest. Typically the switching frequency of operation of a driver lies in the range of 2 - 16 kHz.

Presently the main technique employed to avoid such problems is to ensure that the default switching frequency is sufficiently distinct from the filter resonant frequency. This means that, at certain switching frequencies, the filter will fail. In traditional filter design it is known to suppress the resonance in the filter by employing a certain amount of damping. The damping normally takes the form of a resistance being placed in series with the capacitors. Nevertheless, this dramatically reduces the source impedance whereby to source charging spikes and the motor cable therefore leading to a saturation of the common mode choke and/or reduced filtering. Associated with charging spikes is undesirable electromagnetic interference. Presently there is a general tendency to implement electromagnetic interference controls (EMC) to reduce electromagnetic interference levels.

EP 1220432 discloses a drive controller in accordance with the preamble of the independent apparatus claim.

### OBJECT OF THE INVENTION

The present invention seeks to provide an improved drive controller/inverter. In particular, the present invention seeks to provide a controller which is operable to achieve proposed and future increasingly stringent EMC requirements.

### STATEMENT OF INVENTION

In accordance with a first aspect of the present invention, there is provided a drive controller as set forth in the independent claim.

The filter network comprises a bi-directional set of diodes operable to control cable charging spikes and capacitors operable to filter signals whereby to provide a low impedance to source the charging spikes, the resistance dissipating the energy of any charging spikes and to reducing resonance. By reducing resonance, the common mode choke has a reduced likelihood of becoming saturated. The invention thus relates to an insulated gate bipolar transistor arrangement for a drive controller wherein a DC link to the insulated gate bipolar transistor comprises a filter to earth potential with the link having bi-directional diodes, operable to reduce resonance.

The invention, whilst specifically being described in relation to drive controllers with inverters is applicable to all such forms of controllers wherein pulses of common mode noise need to be suppressed. The first part of a filter network can be considered to provide filtered mains for the rectifier.

In accordance with a second aspect of the invention, there is provided a method of driving a drive controller as recited in the independent method claim.

### BRIEF DESCRIPTION OF THE FIGURES

The invention may be understood more readily, and various other aspects and features of the invention may become apparent, from consideration of the following description and the Figures as shown in the accompanying drawing sheets, wherein:
Figure 1 shows a prior art inverter circuit;
Figure 2 shows an output inverter circuit in accordance with a first embodiment of the invention;
Figure 3 shows an inverter in accordance with a second embodiment of the invention;
Figures 4 and 5 show comparative common mode currents at a resonant frequency of 6kHz spectra for inverters in accordance with the prior art and the present invention; and
Figures 6 and 7 show comparative electromagnetic emission spectra for inverters in accordance with the prior art and the present invention.

### DETAILED DESCRIPTION OF INVENTION

There will now be described, by way of example, the best mode contemplated by the inventor for carrying out the invention. In the following description, numerous specific details are set out in order to provide a complete understanding of the present invention. It will be apparent, however, to those skilled in the art, that the present invention may be put into practice with variations of the specific.

A first embodiment of the invention will now be described with reference to Figure 2, where there is shown an inverter (40) having an AC supply (34) leading to a common mode choke (12), which leads via lead (14) to bridge rectifier (16). As with the prior art inverter described in relation to Figure 1, the common mode choke blocks the common mode noise which is diverted via capacitor (28) to earth potential. A DC link (18) connects the bridge rectifier to a bi-polar transistor output stage (20). A second DC link (22) from the bridge rectifier to the output stage is linked via a filter network to earth potential. As with the prior art controller, the first and second DC links correspond to the positive and negative or negative and positive leads to the transistor arrangement, depending upon the basic polarity set-up. The filter network is connected via conductors (52) and (54) to forward and reverse bias diodes with respect to earth potential (32). The connector leads (56) and (60) connect with diodes (42) and (44) respectively on the one hand and via capacitors (46) and (48) to earth potential on the other hand. Conductor leads (56) and (60) are connected by resistor (50). It is believed that the set of diodes enable low impedance to source the charging spikes, whilst the resistor adds damping to the system whereby to suppress the resonance of the circuit. Typical values for the circuit components, for a drive controller operating at 50 - 60 Hz input and 0 - 600 Hz control voltages being around 230 and 400V, (typically) are: capacitors - 100nF; resistors - 500 Ohms; and diodes - fast - 800V, 10nS.

Figure 3 shows a second embodiment wherein the filter circuit (38) of Figure 2 is replaced by a filter circuit (68). Filter circuit (68) differs in that resistor (50) and connecting lead (58) are not present, but resistors are present, in parallel with the diodes. It will be appreciated that numerous equivalent circuits are possible.

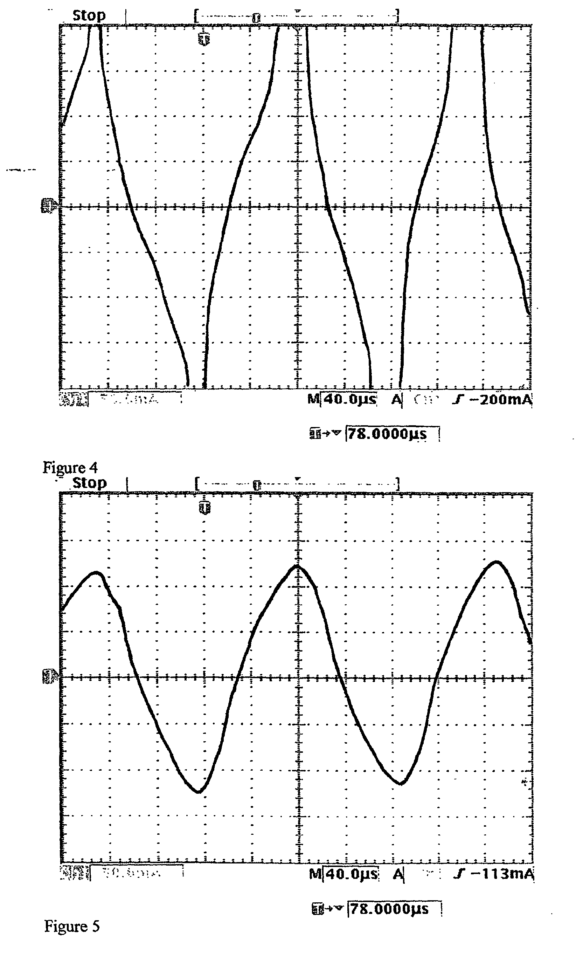

Figures 4 and 5 show comparative common mode currents at a resonant frequency of 6kHz for inverters according to, respectively, Figure 1 and Figure 2. It can clearly be seen that the present invention provides an improvement

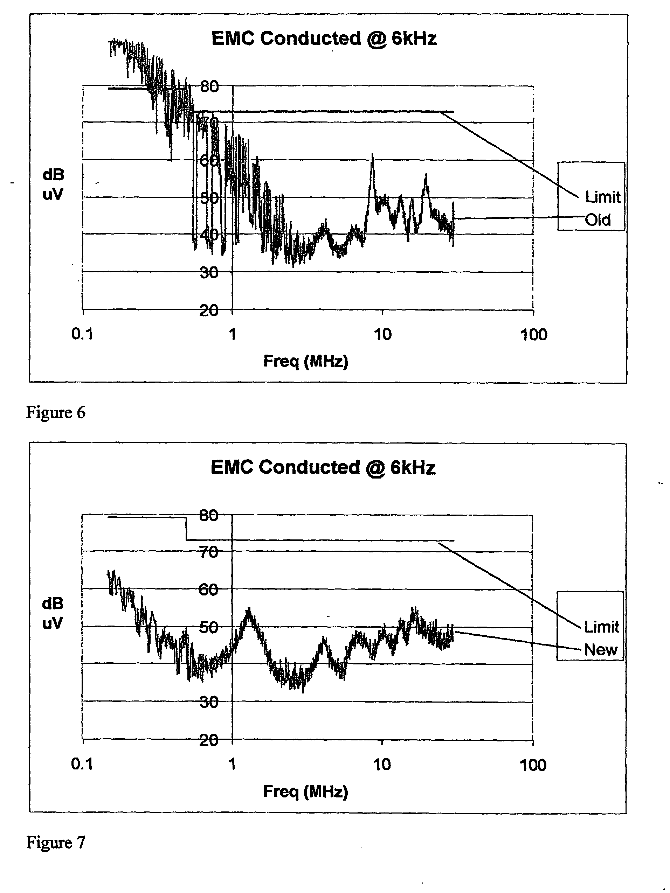

An important area of potential use of the present invention comprises the implementation of control circuits which have to meet certain electro-magnetic interference control (EMC) limits, which are being lowered and therefore are becoming more demanding, for example, those requirements set by EN50081-2. As can be seen from the examples shown, the invention in Figure 7 can provide significant reductions in electro-magnetic interference generation over that provided by prior art circuit configuration of Figure 6. These EMC tests were conducted at a frequency of 6KHz and these Figures show electro-magnetic emission spectra (measured in dB(µv) against frequency MHz).

Whilst the function of a drive is considered to be simple, for example in the case of conveyor belt at the start of a day a drive is switched on, the speed increased to an operating speed and, at the end of the day, speed is reduced and the drive is switched off. In a manufacturing process, the use of a drive may be discontinuous and may be timed or be dependent upon another operation being completed. Different process steps could require different rates of increase in speed; frequency of operation may vary. Special features such as automatic restart following restoration of power subsequent to power failure may also be required. These factors will affect the operational mode of the common mode choke.

## Claims

1. A drive controller comprising an input (34), a common mode choke (12), a rectifier (16), an insulated gate bipolar transistor output stage (20), a filter network (28, 38, 68) and an output (36),
wherein the controller is operable to receive an alternating current electric power supply, and outputs a drive signal via the output (36) with reference to an earth potential (32) via the filter network;
wherein the input (34) is associated with the common mode choke (12) and is operable to receive the power supply, the common mode choke (12) being connected to earth potential (32) via a capacitor (28) comprising a first part of the filter network (28, 38, 68);
wherein the rectifier (16) is connected to the common mode choke (12) and is operable to output signals via a first (18) and a second (22) DC links to the insulated gate bipolar transistor stage (20) connected to earth potential (32) via a second part of the filter network (38, 68); **characterised in that** the second part of the filter network (38, 68) comprises a bi-directional set of diodes (42, 44) for controlling cable charging spikes and a resistance for dissipating the energy of any charging spikes and for reducing resonance, wherein the diodes (42, 44) are connected in forward and reverse bias via respective capacitors (46, 48) to the earth potential (32).

2. A drive controller according to claim 1 wherein a resistor element is placed in parallel with each of the diodes (42, 44).

3. A drive controller according to any one of claims 1 and 2 wherein the first (18) and second (22) DC links correspond to positive and negative inputs to the insulated gate bipolar transistor output stage (20).

4. A drive controller according to any one of claims 1 - 3 wherein the switching frequency of operation lies in the range of 2-16 kHz.

5. A method of driving a drive controller according to claim 1, the method comprising the steps of:
receiving an alternating current electric power supply at the common mode choke;
receiving, at the rectifier, signals from the common mode choke;
outputting signals from the rectifier via a first and second DC links to the insulated gate bipolar transistor stage;
outputting drive signals from the insulated gate bipolar transistor stage;
outputting cable charging spikes by means of the second part of the filter network, comprising the bi-directional set of diodes.

## Patentansprüche

1. Antriebssteuerung, welche einen Eingang (34), eine Gleichtaktdrossel (12), einen Gleichrichter (16), eine IGBT (Insulated Gate Bipolar Transistor)-Ausgangsstufe (20), ein Filternetzwerk (28, 38, 68) und einen Ausgang (36) umfasst,
wobei die Antriebssteuerung dafür vorgesehen ist, eine elektrische Wechselstrom-Stromversorgung aufzunehmen, und über den Ausgang (36) ein Steuerungssignal mit Bezug auf ein Erdpotenzial (32) über das Filternetzwerk ausgibt;
wobei der Eingang (34) mit der Gleichtaktdrossel (12) assoziiert ist und dafür vorgesehen ist, die Stromversorgung aufzunehmen, wobei die Gleichtaktdrossel (12) mit dem Erdpotenzial (32) über einen Kondensator (28) verbunden ist, welcher einen ersten Teil des Filternetzwerks (28, 38, 68) umfasst;
wobei der Gleichrichter (16) mit der Gleichtaktdrossel (12) verbunden ist und dafür vorgesehen ist, Signale über eine erste (18) und eine zweite (22) Gleichstromverbindung an die IGBT-Ausgangsstufe (20) auszugeben, die über einen zweiten Teil des Filternetzwerks (38, 68) mit dem Erdpotenzial (32) verbunden ist;
**dadurch gekennzeichnet, dass** der zweite Teil des Filternetzwerks (38, 68) einen Satz bidirektionaler Dioden (42, 44) zum Kontrollieren von Ladungsspitzen im Kabel sowie einen Widerstand zum Ableiten der Energie eventueller Ladungsspitzen und zum Verringern der Resonanz enthält, wobei die Dioden (42, 44) bei Durchlassvorspannung und bei Sperrvorspannung über jeweilige Kondensatoren (46, 48) mit dem Erdpotenzial (32) verbunden sind.

2. Antriebssteuerung gemäß Anspruch 1, wobei parallel zu jeder der Dioden (42, 44) ein Widerstandselement angeordnet ist.

3. Antriebssteuerung gemäß einem der Ansprüche 1 und 2,
wobei die erste (18) und die zweite (22) Gleichstromverbindung einem positiven bzw. negativen Eingang in die IGBT-Ausgangsstufe (20) entsprechen.

4. Antriebssteuerung gemäß einem der Ansprüche 1 bis 3,
wobei die Schaltfrequenz bei Betrieb im Bereich von 2 bis 16 kHz liegt.

5. Verfahren zum Ansteuern einer Antriebssteuerung gemäß Anspruch 1, wobei das Verfahren die folgenden Schritte umfasst:
Aufnehmen einer elektrischen Wechselstrom-Stromversorgung an der Gleichtaktdrossel;
Aufnehmen von Signalen von der Gleichtaktdrossel am Gleichrichter;
Ausgeben von Signalen von dem Gleichrichter über eine erste und eine zweite Gleichstromverbindung an die IGBT-Ausgangsstufe;
Ausgeben von Steuerungssignalen von der IGBT-Ausgangsstufe;
Ausgeben von Ladungsspitzen im Kabel mithilfe des zweiten Teils des Filternetzwerks, welcher den Satz bidirektionaler Dioden enthält.

## Revendications

1. Dispositif de commande d'entraînement comprenant une entrée (34), une bobine d'arrêt en mode commun (12), un redresseur (16), un étage de sortie à transistor bipolaire à grille isolée (20), un circuit de filtrage (28, 38, 68) et une sortie (36),
en sachant que le dispositif de commande est utilisable pour recevoir une alimentation en énergie électrique sous forme de courant alternatif et sort un signal de commande par la sortie (36) par référence à un potentiel de terre (32) par l'intermédiaire du circuit de filtrage ;
en sachant que l'entrée (34) est associée à la bobine d'arrêt en mode commun (12) et est utilisable pour recevoir l'alimentation en énergie, la bobine d'arrêt en mode commun (12) étant reliée au potentiel de terre (32) par un condensateur (28) constituant une première partie du circuit de filtrage (28, 38, 68) ;
en sachant que le redresseur (16) est relié à la bobine d'arrêt en mode commun (12) et est utilisable pour sortir des signaux par l'intermédiaire d'une première (18) et d'une seconde (22) liaisons à courant continu à destination de l'étage à transistor bipolaire à grille isolée (20) relié au potentiel de terre (32) par une deuxième partie du circuit de filtrage (38, 68),
**caractérisé en ce que** la deuxième partie du circuit de filtrage (38, 68) comprend un jeu bidirectionnel de diodes (42, 44) pour limiter les pointes de charge du câble et une résistance pour dissiper l'énergie de toute pointe de charge et pour réduire la résonance, les diodes (42, 44) étant reliées en polarisation directe et inverse par des condensateurs (46, 48) respectifs au potentiel de terre (32).

2. Dispositif de commande d'entraînement selon la revendication 1 dans lequel un élément résistant est placé parallèlement à chacune des diodes (42, 44).

3. Dispositif de commande d'entraînement selon l'une quelconque des revendications 1 et 2 dans lequel les première (18) et seconde (22) liaisons à courant continu correspondent à des entrées positive et négative destinées à l'étage de sortie à transistor bipolaire à grille isolée (20).

4. Dispositif de commande d'entraînement selon l'une quelconque des revendications 1-3 dans lequel la fréquence de commutation en fonctionnement se situe dans la fourchette de 2-16 kHz.

5. Procédé de commande d'un dispositif de commande d'entraînement selon la revendication 1, le procédé comprenant les étapes consistant :
à recevoir une alimentation en énergie électrique sous forme de courant alternatif au niveau de la bobine d'arrêt en mode commun ;
à recevoir, au niveau du redresseur, des signaux de la bobine d'arrêt en mode commun ;
à sortir des signaux du redresseur par l'intermédiaire d'une première et d'une seconde liaisons à courant continu à destination de l'étage à transistor bipolaire à grille isolée ;
à sortir des signaux de commande de l'étage à transistor bipolaire à grille isolée ;
à sortir des pointes de charge de câble au moyen de la deuxième partie du circuit de filtrage, constitué par le jeu bidirectionnel de diodes.
